# EUROPÄISCHE PATENTANMELDUNG

(11) **EP 2 543 671 A1**
(43) Veröffentlichungstag der Anmeldung: **09.01.2013**
(21) Anmeldenummer: 11175122.8
(22) Anmeldetag: 22.07.2011
(51) Int. Cl.: C07F 1/08, C08J 3/24, H01L 51/00, C08F 12/08, C08G 79/00, C09K 11/00, C09K 11/66, H05B 33/14

(54) **Querverknüpfung und Stabilisierung von organischen Metallkomplexen in Netzwerken**

(30) Priorität: 08.07.2011 EP 11173374
(71) Anmelder: cynora GmbH, 76344 Eggenstein-Leopoldshafen (DE)
(72) Erfinder: Baumann, Thomas, 76131 Karlsruhe (DE); Grab, Tobias, 76133 Karlsruhe (DE); Bächle, Michael, 76133 Karlsruhe (DE); Volz, Daniel, 76131 Karlsruhe (DE)
(74) Vertreter: Hoppe, Georg Johannes

(57) **Zusammenfassung**

Die Erfindung betrifft ein Verfahren zur Herstellung eines in einem mehrdimensionalen Netzwerk querverknüpften organischen Metallkomplexes, umfassend das Durchführen einer ersten Reaktion, die einen ersten Reaktanden in Form eines organischen Metallkomplexes und einen zweiten Reaktanden zur Ausbildung eines mehrdimensionalen Netzwerkes aufweist, wobei der Metallkomplex während der Reaktion in dem sich bildenden mehrdimensionalen Netzwerk querverknüpft wird.

## Beschreibung

Die Erfindung betrifft organische Metallkomplexe und deren Querverknüpfung (Quervernetzung) in einem mehrdimensionalen Netzwerk. Insbesondere betrifft die Erfindung ein Verfahren zur Herstellung eines in einem mehrdimensionalen Netzwerk querverknüpften organischen Metallkomplexes.

### Einleitung

Phosphoreszierende Übergangsmetallkomplexe gewinnen aufgrund ihrer Eigenschaften als hocheffiziente Emitter in optoelektronischen Bauteilen wie OLEDs zunehmend stärker an Bedeutung. Die vom Übergangsmetallatom (Schwermetallatom) induzierte Spin-Bahn-Kopplung resultiert in einer erhöhten Intersystem-Crossing-Rate vom angeregten Singulett- zum Triplett-Zustand und somit zu einer Nutzung sowohl der Singulett- als auch der Triplett-Exzitonen für die Emission und ermöglicht dadurch eine theoretisch erreichbare innere Quantenausbeute von 100 %.

Diese phosphoreszierenden Farbstoffe werden üblicherweise in entsprechende energetisch angepasste Hostmaterialien eingebracht. Aufgrund der leichteren Verarbeitbarkeit durch flüssige Prozessierung aus der Lösung eignen sich hierfür insbesondere polymere Strukturen. Diese sollten im Idealfall weitere Aufgaben wie eine räumliche Trennung der Farbstoffmoleküle zur Vermeidung unerwünschter Konzentrations-Quenchprozesse und Triplett-Triplett-Annihilierung unter Emissionsminderung, verbesserte Ladungsträgerinjektion und -transport und eine erhöhte Rekombinationswahrscheinlicheit direkt auf den Emittermolekülen übernehmen.

Demnach stellt die Kombination geeigneter polymerer Hoststrukturen mit entsprechenden statistisch eingemischten Emitterverbindungen und zusätzlich eingebrachten Ladungstransportmolekülen eine vielfältig angewandete Methode zur Herstellung polymerer lichtemittierender Dioden (PLEDs) dar. Obwohl die auf diese Art dargestellten OLED-Bauteile meist hohe Effizienzen aufweisen, können diese Mischsysteme jedoch unerwünschten Phasenseparierungen, Aggregierungen oder Kristallisationsprozessen unterliegen, die sich nachteilig auf die Leistungsfähigkeit und Lebensdauer der Bauteile auswirken. Somit ist die Herstellung angepasster (Co)polymere, die unterschiedliche Funktionen wie Ladungstransport und Emission übernehmen bei gleichzeitiger Nutzung der Vorteile der flüssigen Verarbeitung von stetig zunehmendem Interesse.

Zur Synthese phosphoreszierender Polymere mit kovalent angebundenen Übergangsmetallkomplexen stehen im Stand der Technik prinzipiell zwei unterschiedliche Routen zur Verfügung: zum einen die nachträgliche Anbindung der Metallkomplexe an die vorher dargestellten, mit funktionellen Gruppen versehenen Polymere ("Komplexierung am Polymer"), zum anderen die Polymerisation entsprechender, die Metallkomplexe tragender Monomere ("Polymerisation von Komplex-Monomeren").

Die erste Strategie erlaubt einen modularen Aufbau mit der prinzipiellen Anbindung einer Vielzahl unterschiedlicher Metallkomplexe ans Polymer, und bietet als einen Vorteil die eingehende und genauere Untersuchung der vorher synthetisierten, metallfreien Polymere mittels gängiger Polymeranalytik wie beispielsweise GPC und NMR. Zusätzlich kann theoretisch der Metallkomplexgehalt im finalen Polymer durch sorgfältige Einstellung der potentiellen Koordinationsstellen variiert werden. Notwendig für den Erfolg des modularen Post-Polymerisationsverfahrens ist jedoch die Verwendung von zu den eigentlichen Polymerisationsreaktionen orthogonalen Funktionalisierungsmethoden, die zusätzlich in hohen Ausbeuten verlaufen müssen.

Der Vorteil der zweiten Route besteht im kontrollierten Aufbau und quantitativer Funktionalisierung der Metallkomplexe durch Nutzung gängiger Polymerisationsverfahren, die teilweise jedoch auf die entsprechenden Metallkomplex-funktionalisierten Monomere angepasst werden müssen und deren genaue Charakterisierung durch allgemeine Analytikverfahren aufgrund der angebundenen Metallkomplexe meist nicht möglich ist.

Beiden Methoden gemein ist die Tatsache, dass die effizienten Emitterkomplexe an ein polymeres Hostsystem angebunden werden und somit einer flüssigen Prozessierung zugeführt werden können; dennoch unterliegen sie den Nachteilen einer möglichen Mehrschichtanordnung: Die kostengünstige Flüssigprozessierung von Polymeren erlaubt keine einfache sequentielle Auftragung definierter, dünner Schichten. Dies ist in der generellen Löslichkeit der polymeren Materialien begründet. Für die notwendige Materialstärke ist eine relativ große Menge Lösungsmittel notwendig und bereits abgetrocknete Schichten lösen sich beim Auftragen darauffolgender Schichten erneut an, wobei die notwendige Schichtanordnung wieder gelöst wird.

Bisherige Lösungen dieses Problems bestehen in der Entwicklung querverknüpfbarer Materialien mit negativ Photoresist-ähnlichen Eigenschaften, die nach Aufbringung aus der Lösung durch Belichtung oder thermische Behandlung querverknüpft werden und somit unlösliche Schichten ausbilden. Beispielsweise berichten Frechet und Mitarbeiter von einer Reihe querverknüpfbarer heteroleptischer Ir(III)-Komplexe zur Anwendung in flüssigprozessierbaren phosphoreszenten OLEDs, die in der Ligandensphäre zwei querverknüpfbare Vinylbenzylether-Einheiten tragen, die durch Erhitzen auf 180 °C vollständig querverknüpft werden können (Multifunctional Crosslinkable Iridium Complexes as Hole TransportinglEiectron Blocking and Emitting Materials for Solution-Processed Multilayer Organic Light-Emitting Diodes, Biwu Ma, Bumjoon J. Kim, Daniel A. Poulsen, Stefan J. Pastine, Jean M. J. Fréchet, Adv. Funct. Mater. 2009, 19, 1024-1031). Die querverknüpften Filme weisen hohe Lösungsmittelresistenzen und sehr gute Filmbildungseigenschaften auf, wodurch die prinzipielle Herstellung von Mehrschichtsystemen durch sequentielle Flüssigprozessierung unterschiedlicher Schichten möglich wird. Dennoch stellt dieses Vorgehen keinen kontrollierten Aufbau wohldefinierter Metallkomplex-funktionalisierter Polymere dar, da die Polymerisation nur durch thermische Prozesse und vollständig unkontrolliert abläuft. Hierbei ist es beispielsweise nicht möglich, durch kontrollierte Polymerisationsverfahren das Molekulargewicht, die Kettenlänge und die Polydispersität des Polymers exakt einzustellen, reproduzierbar durchzuführen und für die Anforderungen einer standardisierten Flüssigprozessierung entsprechend anzupassen.

### Beschreibung

Die Erfindung betrifft in einem ersten Aspekt ein Verfahren zur Herstellung eines in einem - bevorzugt unlöslichen - mehrdimensionalen Netzwerk querverknüpften organischen Metallkomplexes. Dieses Verfahren umfasst das Durchführen einer ersten Reaktion, die die Umsetzung eines ersten Reaktanden in Form eines organischen Metallkomplexes mit einem zweiten (und zum ersten Reaktanden unterschiedlichen) Reaktanden umfasst. Der zweite Reaktand dient der Ausbildung eines mehrdimensionalen Netzwerkes.

Während dieser ersten Reaktion wird der Metallkomplex in dem sich bildenden mehrdimensionalen Netzwerk querverknüpft, d. h. es bilden sich mindestens zwei Bindungen des Metallkomplexes mit dem aus dem zweiten Reaktanden gebildeten mehrdimensionalen Netzwerk aus. Dies kann in seiner einfachsten Ausprägung einer leiterähnliche (zweidimensionale) Struktur sein, bei der zwei Netzwerkstränge durch mindestens einen Metallkomplex verknüpft sind, der mit je einem der Stränge mindestens eine kovalente Bindung ausbildet. Weiterhin sind komplizierte dreidimensionale Netzwerke als Produkt der ersten Reaktion möglich, die mittels einer variablen Zahl von Netzwerksträngen querverknüpfte Metallkomplexe umfassen. Der querverknüpfte Metallkomplex ist somit im mehrdimensionalen Netzwerke immobilisiert.

Zur kovalenten Verknüpfung des organischen Metallkomplexes an den zur Ausbildung eines mehrdimensionalen Netzwerkes geeigneten zweiten Reaktanden stehen unterschiedliche Strategien zur Verfügung. Dabei werden allgemein Paare miteinander korrespondierender chemischer Gruppen verwendet, die miteinander eine kovalente chemische Bindung ausbilden können. Diese chemischen Gruppen, die hier auch als Ankergruppen bezeichnet werden, gehören einer ersten Ankergruppenspezies oder einer zweiten Ankergruppenspezies an, wobei Ankergruppen der ersten Ankergruppenspezies mit Ankergruppen der zweiten Ankergruppenspezies eine kovalente Bindung ausbilden können, nicht aber Ankergruppen einer ersten Ankergruppenspezies untereinander oder Ankergruppen einer zweiten Ankergruppenspezies untereinander.

Bei einer ersten bevorzugten Strategie der kovalenten Verknüpfung des organischen Metallkomplexes an den zweiten Reaktanden weist der Metallkomplex mindestens zwei Ankergruppen einer ersten Ankergruppenspezies auf, die der kovalenten Einbindung des Metallkomplexes in das mehrdimensionale Netzwerk dienen. Der zweite Reaktand weist mindestens eine Ankergruppe einer zweiten Ankergruppenspezies, die zur Bindung des zweiten Reaktanden an eine erste Ankergruppe des Metallkomplexes geeignet ist. Die Querverknüpfung des Metallkomplexes in das mehrdimensionale Netzwerk erfolgt durch Reaktion der mindestens zwei Ankergruppen des Metallkomplexes mit je einer zweiten Ankergruppe eines zweiten Reaktanden.

Bei einer zweiten bevorzugten Strategie der kovalenten Verknüpfung des organischen Metallkomplexes an den zweiten Reaktanden nimmt ein dritter Reaktand an der ersten Reaktion teil, der auch als "Spacer"-Molekül bezeichnet werden kann.

Dabei weist der Metallkomplex mindestens zwei Ankergruppen einer ersten Ankergruppenspezies auf, der zur kovalenten Einbindung des Metallkomplexes in die Matrix über einer zweiten Ankergruppe geeignet ist. Der zweite Reaktand weist eine Ankergruppe einer ersten Ankergruppenspezies auf, die der Bindung des zweiten Reaktanden an eine zweite Ankergruppe dient, so dass der Metallkomplex nicht unmittelbar an den zweiten Reaktanden binden kann. Zur Ausbildung einer kovalenten Bindung zwischen Metallkomplex und zweitem Reaktanden wird ein dritter Reaktand zugegeben, der zwei Ankergruppen einer zweiten Ankergruppenspezies aufweist, wobei jede dieser Ankergruppen des dritten Reaktanden mit je einer ersten Ankergruppe (nämlich des Metallkomplexes und des zweiten Reaktanden) eine kovalente Bindung eingehen kann. Somit erfolgt die Querverknüpfung des Metallkomplexes in das mehrdimensionale Netzwerk durch Reaktion der Ankergruppe des Metallkomplexes und durch Reaktion der Ankergruppe des zweiten Reaktanden mit demselben dritten Reaktanden.

Dieser dritte Reaktand ("Spacer"-Molekül), kann z. B. eine Alkylkette einer gewünschten Kettenlänge sein, das an zwei voneinander beabstandeten Molekülteilen, z. B. einander gegenüberliegenden Enden, je eine Ankergruppe aufweist, der die Anbindung an Metallkomplex bzw. zweiten Reaktanden vermittelt. Neben Alkylketten sind auch Aryl-, Heteroaryl-, Alkenyl-, Alkinyl-, Trialkylsilyl- und Triarylsilyl-Gruppen bzw. substituierte Alkyl-, Aryl-, Heteroaryl- und Alkenyl-Gruppen, optional mit Substituenten wie Halogenen, niedrigen Alkylgruppen und/oder elektronenschiebenden und - ziehenden Gruppen, sowie gängigen Ladungstransporteinheiten wie beispielsweise Arylamine, Carbazole, Benzimidazole, Oxadiazole etc. möglich. Die Substituenten können auch zu anellierten Ringsystemen führen.

Bevorzugter Weise sind der Metallkomplex und der zweite Reaktand in einem gängigen (bevorzugt zur OLED-Bauteilherstellung) organischen Lösemittel löslich. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol und Tetrahydrofuran. In einer bevorzugten Ausgestaltung der Erfindung ist das gebildete mehrdimensionale Netzwerk mit querverknüpften organischen Metallkomplexen unlöslich, was insbesondere die Ausbildung einer Struktur mehrerer übereinanderliegender Schichten eines derartigen mehrdimensionalen Netzwerks in einfacher Weise möglich macht.

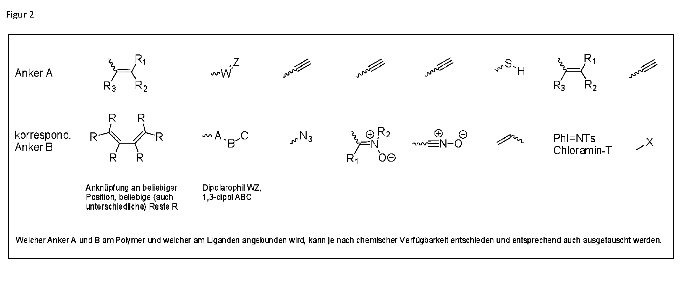

Die erste und zweite Ankergruppe können insbesondere ausgewählt sein aus der in Figur 2 gezeigten Gruppe chemischer Reste. Sofern es sich bei dem Metallkomplex um einen Emitter handelt, steht die Ankergruppe bevorzugter weise nicht in Konjugation zum Emittersystem, um die Emission des Komplexes nicht zu beeinflussen.

Grundsätzlich kann jedweder organischer Übergangsmetallkomplex in dem Verfahren verwendet werden, der an mindestens einem seiner Liganden eine erste Ankergruppe trägt. Insbesondere weist der Metallkomplex neben der ersten Ankergruppe mindestens ein Metallzentrum und mindestens einen organischen Liganden auf. Der Metallkomplex kann ein- oder mehrkernig (zwei-, drei-, vierkernig, etc.) sein und kann einen oder mehrere Liganden tragen. Die Liganden können ein- oder mehrzähnig sein. Sofern ein einkerniger Komplex nur einen Liganden trägt, ist dieser Ligand mehrzähnig. Wenn der Komplex nicht neutral ist, ist ein entsprechendes Gegenion bereitzustellen, das aber bevorzugt nicht an der ersten Reaktion wie hier beschrieben teilnimmt.

Bevorzugte organische Metallkomplexe sind beispielsweise Lichtemitter, die in optoelektronischen Bauteilen, wie OLEDs eingesetzt werden können. Eine weitere Gruppe bevorzugte Metallkomplexe sind Halbleiter. Derartige emittierende und halbleitende Metallkomplexe sind im Stand der Technik bekannt.

Mindestens ein Ligand des Metallkomplexes weist eine erste Ankergruppe auf. Insgesamt weist ein Metallkomplex zwei Ankergruppen bevorzugt einer Ankergruppenspezies auf, die an einem oder bevorzugt auf zwei Liganden des Metallkomplexes verteilt angeordnet sein können. Es ist somit auch möglich, dass mehrere Liganden eines Metallkomplexes eine oder mehrere Ankergruppen aufweisen, wobei die Anzahl der Ankergruppen an dem Metallkomplex und an dem zweiten Liganden den Querverknüpfungsgrad bestimmt.

Das mehrdimensionale Netzwerk ist ein zweidimensionales oder dreidimensionales Netzwerk. Bevorzugt ist ein dreidimensionales Netzwerk.

Der in dem Verfahren verwendete zweite Reaktand kann aus der Gruppe bestehend aus einem Monomer, einem Oligomer und einem Polymer ausgewählt sein. Als Monomer werden hier niedermolekulare, reaktionsfähige Moleküle bezeichnet, die zu molekularen Ketten oder Netzen, zu unverzweigten oder verzweigten Polymeren, reagieren können. Beispiele sind gängige Monomere wie Styrol, Ethylen, Propylen, Vinylchlorid, Tetrafluorethylen, Acrylsäuremethylester, Methacrylsäuremethylester, Bisphenol A/Phosgen, Ethylenglykole, Terephthalsäuren und Organochlorsilane. Als Oligomer wird hier ein Molekül bezeichnet, die aus 2 bis zu 30 strukturell gleichen oder ähnlichen Einheiten aufgebaut ist. Beispiele für Oligomere sind Oligoethylen, Oligopropylen, Oligovinylchlorid, Oligotetrafluorethylen, Oligoacrylsäuremethylester, Oligomethacrylsäuremethylester, Oligocarbonate, Oligoethylenglykol, Oligoethylenterephthalat, Oligo(organo)siloxane. Polymere sind Moleküle, die aus mehr als 30 strukturell gleichen oder ähnlichen Einheiten aufgebaut sind. Beispiele für Polymere sind Polystyrol, Polyethylen, Polypropylen, Polyvinylchlorid, Polytetrafluorethylen, Polyacrylsäuremethylester, Polymethacrylsäuremethylester, Polycarbonate, Polyethylenglykol, Polyethylenterephthalat, Poly(organo)siloxane.

Angeknüpft werden können also nicht nur Polymere, sondern auch niedermolekulare Oligomere mit zwei oder mehr Ankergruppen oder Monomere, über die etwa weitere Funktionalitäten in die Peripherie der Komplexe gebracht werden können, was neue Möglichkeiten hinsichtlich des Ladungstransports und der Ladungsträgerrekombination in organischen Halbleitern eröffnet. Der Begriff Monomer schließt in einer Ausführungsform niedermolekulare anorganische Verbindungen mit ein, wie z. B. Phosphaalkene, Phosphazene, Ferrocenylsilane, Ferrocenylphosphane.

Die hier beschriebene Querverknüpfung eines Metallkomplexes ist von der Einführung eines Komplexes in ein Polymer zu unterscheiden, bei der der Komplex an jeweils nur einen Polymerstrang angebunden wird und sich dadurch nur die Löslichkeitseigenschaften des angebundenen Komplexes ändern. Auch ist eine Querverknüpfung bisher nur zwischen nicht metall-angebundenen Polymeren bekannt, wobei immer nur Polymere mit sich selbst eine Querverknüpfungsreaktion eingehen, also nur homo-querverknüpft werden. Demgegenüber wird erfindungsgemäß nur durch die Ausbildung einer Bindung an den Metallkomplex eine Querverknüpfung ausgelöst, wodurch die entsprechenden Polymere mit dem Metallkomplex hetero-querverknüpft werden.

Die Erfindung betrifft mit anderen Worten Materialien, insbesondere flüssig-prozessierbare optoelektronische Materialien, die durch ihren speziellen Aufbau gleichzeitig sowohl die kovalente Anbindung eines Metallkomplexes, beispielsweise eines hocheffizienten Emitter-Metallkomplexes, an einen entsprechend funktionalisierten zweiten Reaktanden wie an ein Monomer, Oligomer oder Polymer, als auch dessen Quervernetzung und somit Unlöslichkeitsmachung ermöglichen.

In einer bevorzugten Ausführungsform der Erfindung wird neben dem Metallkomplex, dem zweiten Reaktanden und optional dem dritten Reaktanden, ein vierter Reaktand in der ersten Reaktion des Verfahrens eingesetzt, wobei es sich um eine loch- oder elektronenleitende chemische Gruppe und/oder um eine ladungsblockierende chemische Gruppe handelt, die als Ladungstransport- bzw. Ladungsblockiereinheit ebenfalls quervernetzt werden kann. Beispiele für loch- oder elektronenleitende chemische Gruppen sind Arylamine wie N,N'-bis(naphthalen-1-yl)-N,N'-bis(phenyl)-benzidin, N,N'-bis(naphthalen-1-yl)-N,N'-bis(phenyl)-2,2'-dimethylbenzidin, Carbazole wie 4,4-Bis(carbazol-9-yl)biphenyl, 1,3-Bis(carbazol-9-yl)benzol, Benzimidazole wie 1,3,5-Tris(1-phenyl-1H-benzo[d]imidazol-2-yl)benzol, Oxadiazole wie 2-(4-Biphenyl)-5-(4-tert-butylphenyl)-1,3,4-oxadiazol, Triazole wie 3-(4-Biphenyl)-4-phenyl-5-tert-butylphenyl-1,2,4-triazol, 4-(Naphthalen-1-yl)-3,5-diphenyl-4H-1,2,4-triazol.

Zum Zwecke der Anbindung in das mehrdimensionale Netzwerk weist der vierte Reaktand ebenfalls mindestens eine Ankergruppe der ersten und/oder zweiten Ankergruppenspezies auf, abhängig davon, ob der vierte Reaktand an den Metallkomplex oder den zweiten Reaktanden gebunden werden soll.

Die Erfindung besteht in einem Stabilisierungs- und Vernetzungsverfahren von Metallkomplexen durch Monomere, Oligomere und Polymere, die aus einem oder mehreren Metallen und einem mindestens zweizähnigen oder mehreren ein- oder mehrzähnigen Liganden bestehen. Erfindungsgemäß tragen der organische Metallkomplex und der zweite Reaktand komplementäre chemische Anker einer (ersten bzw. zweiten) Ankergruppenspezies, die in einer möglichst schnell und vollständig ablaufenden Reaktion kovalent miteinander verbunden werden. So können beispielsweise lumineszierende oder halbleitende Metallkomplexe z. B. für Anwendungen in der organischen Elektronik immobilisiert werden, um die Lebensdauer und Langzeitstabilität der entsprechenden Bauteile zu erhöhen.

Bevorzugt sind dabei solche im Stand der Technik als "Click-Chemie" bezeichnete, energetisch begünstigte Reaktionen, die spezifisch verlaufen und ein einzelnes Produkt ergeben (H. C. KoIb, M. G. Finn, K. B. Sharpless, Angew. Chem. Int. Ed. 2001, 40, 2004 -2021). Die "Click-Chemie" umfasst somit Reaktionen, die mit hohen Ausbeuten durchführbar sind, ein breites Anwendungsspektrum aufweisen, (stereo)spezifisch ablaufen, einfache Reaktionsbedingungen (möglichst unempfindlich gegen Wasser und Sauerstoff) aufweisen, einfach entfernbare, möglichst ungefährliche Nebenprodukte und Reagenzien (falls überhaupt) aufweisen, in umweltfreundlichen und/oder leichtentfernbaren Lösungsmitteln wie Wasser oder lösungsmittelfrei ablaufen und/oder eine einfache Aufreinigung (Extraktion, Phasentrennung, Destillation oder Kristallisation - möglichst keine Chromatographie) oder gar keine Aufreinigung benötigen.

"Click"-Reaktionen sind zumeist stark thermodynamisch begünstigt, mit oft mehr als 20 kcal mol⁻¹, was in schnellem Umsatz mit hoher Selektivität zu einem einzelnen Produkt resultiert. Mit Click-Reaktionen werden meist Kohlenstoff-Heteroatom Bindungen gebildet.

Insbesondere können nucleophile Substitutionen, besonders Ringöffnung von gespannten, elektrophilen Heterozyklen wie Epoxide und Aziridine, Carbonyl-Chemie des "Non-Aldol"-Typs wie die Bildung von aromatischen Heterocyclen oder Hydrazonen, Additionen an Kohlenstoff-Kohlenstoff-Doppelbindungen wie die oxidative Bildung von Epoxiden und Aziridinen, Dihydroxylierung und Michael-Additionen, sowie Cycloaddition an ungesättigte C-C-Bindungen, besonders 1,3-dipolare Cycloadditionen und Diels-Alder-Reaktionen gemäß der Erfindung verwendet werden. Weitere Beispiele für solche Reaktionen sind Kreuzkupplungsreaktionen zur Knüpfung von C-C-Bindungen wie die Ullmann-Reaktion, die Sonogashira-Reaktion und die Glaser-Kupplung. Alle diese Reaktionen sind dem Fachmann bekannt.

Für die beschriebene Erfindung sind solche Reaktionen relevant, die ohne den Zusatz eines weiteren Reaktanden (also über den ersten, zweiten und ggf. dritten und ggf. vierten hinaus), auskommen, wobei ein Katalysator nicht als Reaktand angesehen wird. Beispiele für solche Reaktionen sind neben den oben erwähnten 1,3-dipolaren Cycloadditionen und Diels-Alder-Reaktionen Nitron-Alkin-, Nitriloxid-Alkin-, Thiol-En-, Thiol-In-, Thiol-Isocyanat, Tetrazol-Alken- und andere in der chemischen Literatur als Click-Reaktionen bekannte Verfahren.

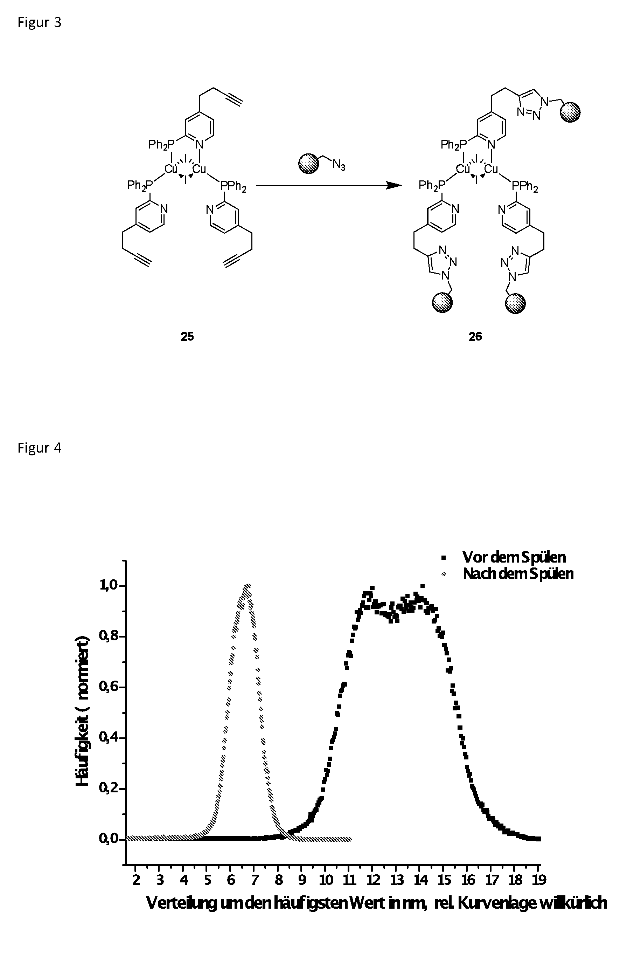

In einer vorteilhaften Ausgestaltung des Verfahrens findet die Reaktion in Gegenwart eines Katalysators zur Katalyse der Reaktion statt. Bevorzugter Weise weist der Metallkomplex den Katalysator auf, d. h. das im organischen Metallkomplex enthaltene Metallzentrum dient gleichzeitig als Katalysator, so dass eine autokatalysierten Quervernetzung stattfindet. Als Beispiel hierfür ist in Figur 3 die Kupfer-katalysierte Clickreaktion zwischen einem terminalen oder aktivierten Alkin als erster Ankergruppe einer ersten Ankergruppenspezies und einem Azid als Ankergruppe einer zweiten Ankergruppenspezies dargestellt.

Mittels eines Cu(I) Katalysators verläuft z. B. die klassische 1,3-dipolare Cycloaddition (Huisgen-Cyclisierung), die ansonsten recht hohe Temperaturen erfordert, regiounspezifisch verläuft und sich daher grundsätzlich nicht als "Click"-Reaktion eignet (V. V. Rostovtsev, et al., Angew. Chem. Int. Ed. 2002, 41, 2596-2599; C. W. Tornøe, et al., J. Org. Chem. 2002, 67, 3057) gegenüber der klassischen Cyclisierung bis zu 10⁷ mal schneller, regioselektiv (nur das 1,4-Regioisomer wird gebildet), auch in Wasser, bei Raumtemperatur und ist dabei unempfindlich gegenüber den meisten anderen funktionellen Gruppen, wie beispielsweise Alkoholen, Säuren und Säurederivaten, Carbonylverbindungen, Halogenen etc.

Der Katalysator kann z. B. aus Cu(II) Spezies *in situ* hergestellt werden. Es kann CuSO₄ mit Natriumascorbat oder Cu(0) als Reduktionsmittel verwendet werden, aber auch andere stabilisierte Cu(I) Salze und Komplexe sind möglich. In einer bevorzugten Ausführungsform ist der Metallkomplex ein Cu(I) oder Cu(II)-Komplex, so dass die Reaktion autokatalytisch erfolgt. Andere mögliche Katalysatoren sind Pt, Pd, Au und Ag.

Die Reaktion zwischen Metallkomplex und zweitem Reaktanden verläuft bevorzugt bei einer Temperatur, die größer ist als Raumtemperatur. Bevorzugt sind mindestens 50 °C, besonders bevorzugt sind Temperaturen von 80 °C bis 120 °C. Die für die jeweilige Reaktionstemperatur benötigte Reaktionszeit kann von einem Fachmann leicht bestimmt werden. Im Allgemeinen ist mit einer Reaktionszeit von 1 Minute bis 60 Minuten, bevorzugt von 10 Minuten bis 30 Minuten zu rechnen, so dass der Metallkomplex immobilisiert und damit stabilisiert und unlöslich ist. Die thermische Aktivierung kann dabei auch durch Bestrahlung mit Mikrowellen erfolgen, wodurch die Reaktionszeiten meist deutlich auf kleiner als 1 Minute verkürzt werden können.

Neben einer thermischen Aktivierung der Reaktion des Verfahrens kann in einer Ausführungsform der Erfindung auch eine photochemische Aktivierung, erfolgen. Dies führt im Vergleich zur thermischen Aktivierung meist zu verkürzten Reaktionsdauern, die kleiner als 1 Minute betragen können. Daher kann eine photochemisch aktivierte Reaktion auch ohne Katalysator durchgeführt werden. Eine Reaktion in Anwesenheit eines Katalysators ist ebenfalls möglich.

Ist eine Ankergruppe, z. B. ein Alkin-Linker, in Konjugation zu einem organischen Liganden des Metallkomplexes vorhanden und wird ein aromatisches Azid als komplementäre Ankergruppe verwendet, so lassen sich die Emissionsfarben solcher emittierender Komplexe, die auf Charge-Transferübergängen zwischen den Metallionen und den Liganden beruhen, beeinflussen. Bevorzugt sind in diesem Zusammenhang Metallkomplexe mit drei Liganden oder mehr (z. B. vier, fünf oder sechs Liganden), da damit drei Anknüpfstellen oder mehr (z. B. vier, fünf oder sechs Anknüpfungsstellen) vorhanden sind. Somit lassen sich die Komplexe auf diese Weise sowohl an die Polymere anknüpfen, als auch mit Loch- oder Elektronenleitern (vierten Reaktanden) verbinden. Die optischen, mechanischen und elektrischen Eigenschaften der so erhaltenen Substanzen lassen sich damit über die jeweilige Zusammensetzung des Azid-Gemisches beeinflussen.

Mittels des hier beschriebenen Verfahrens ist es möglich, mehrere Schichten immobilisierter Metallkomplexe in einfacher Weise übereinander anzuordnen, ohne dass z. B. orthogonale Lösungsmittel verwendet werden müssen.

Zur Herstellung einer Mehrschichtanordnung wird nach der oben beschriebenen ersten Reaktion eine zweite Reaktion durchgeführt. Diese zweite Reaktion umfasst einen fünften Reaktanden in Form eines organischen Metallkomplexes und einen sechsten, bevorzugt löslichen Reaktanden zur Ausbildung eines bevorzugt unlöslichen mehrdimensionalen Netzwerkes, wobei der Metallkomplex während der zweiten Reaktion in dem sich bildenden mehrdimensionalen Netzwerk querverknüpft wird. Hinsichtlich spezieller Ausgestaltungen der zweiten Reaktion gilt das für die erste Reaktion gesagte entsprechend.

Dabei kann der fünfte Reaktand der zweiten Reaktion zu dem ersten Reaktanden der ersten Reaktion identisch oder verschieden sein. Ebenso kann der sechste Reaktand der zweiten Reaktion zu dem zweiten Reaktanden der ersten Reaktion identisch oder verschieden sein.

Die erfindungsgemäß erfolgende Quervernetzung erlaubt eine schnelle und einfache Anordnung beliebig vieler photoaktiver Schichten, deren Löslichkeit nicht wie in bisherigen Systemen exakt aufeinander abgestimmt werden müssen. Dies hat eine deutliche Vereinfachung in der Verarbeitung zur Folge, da die Auswahl der einzelnen aktiven Schichten nicht mehr bezüglich der Löslichkeit zueinander orthogonal sein muss, sondern nahezu unabhängig voneinander kombiniert werden kann. Dies erlaubt somit die sequentielle Auftragung beliebig vieler unterschiedlicher Schichten und führt dadurch zu einer signifikanten Verbesserung der Effizient und Haltbarkeit.

In einer bevorzugten Ausgestaltung des Verfahrens sind die Ankergruppen der ersten und zweiten Ankergruppenspezies in jeweils äquimolaren Mengen vorhanden, so dass alle Ankergruppen kovalente Bindungen mit komplementären Ankergruppen eingehen können.

In einem zweiten Aspekt betrifft die Erfindung einen in einem mehrdimensionalen Netzwerk querverknüpften organischen Metallkomplex, durch ein hier beschriebenes Verfahren herstellbar ist. Insbesondere in Fällen, in denen der Metallkomplex ein Emitter-Metallkomplex ist, der in optoelektronischen Bauelementen eingesetzt werden kann und soll, besteht ein Vorteil der Erfindung in der Stabilisierung der Geometrie des Emitter-Metallkomplexes durch die Immobilisierung der Quervernetzung.

Es ist bekannt, dass eine Änderung der Geometrie am Emitterkomplex bei der Anregung aus dem Grundzustand in den ersten angeregten Zustand zu größeren Verschiebungen der Energiepotentiale und zu größeren Wahrscheinlichkeiten für nicht-strahlende Relaxationsprozesse führt. Die Geometrie des angeregten Zustands sollte sich daher nicht von derjenigen des Grundzustands unterscheiden. Die mit der Erfindung erreichte räumliche/sterische Stabilisierung von Emittern führt somit zu einer Effizienzsteigerung von Emittern als Metallkomplexe.

Mittels der in der Peripherie der Liganden der als Metallkomplexe, z. B. als Emitterkomplexe, angebundenen Ankergruppen für die verknüpfenden Click-Reaktionen wird die mögliche Bewegung der Liganden des Metallkomplexes zueinander stark eingeschränkt. Die Komplexe werden somit fixiert und stabilisiert. Die Übergangswahrscheinlichkeiten für nicht strahlende Prozesse werden im Gegensatz zu "freien" Komplexen durch Rotation und Verdrillung reduziert: Die Emissions-Quantenausbeute der Emitter werden erhöht. Gleichzeitig führt die Fixierung zu einer maximalen Ausnutzung des energetischen Abstandes zwischen Grund- und erstem angeregten Zustand. Hierdurch kann im Vergleich zum "freien", d.h. nicht quervernetzten Komplex eine Blauverschiebung des Emissionsspektrums stattfinden, da die Besetzung von Rotations- und Schwingungszuständen weniger wahrscheinlich und der Energieunterschied zwischen Grund- und erstem angeregten Zustand (direkte vertikale Anordnung der Potentialkurven, vgl. Franck-Condon-Prinzip, das dem Fachmann bekannt ist) maximiert wird.

Neben der Schichtstabilisierung und dem möglichen Einbau von definierten Loch- und Elektronenleitern verbessert die Erfindung darüber hinaus die Effizienz von optoelektronischen Bauteilen: Durch die sterische Hinderung der Metallkomplexe werden die Überlappintegrale zwischen nicht zur Emission genutzten Zuständen kleiner, die Besetzung von Rotations- und Schwingungszuständen weniger wahrscheinlich. Die Stabilität der Komplexe steigt durch die Verhinderung von Bindungsbrüchen und nicht-strahlenden Relaxationen durch freie Beweglichkeit der Liganden eines Metall-Emittersystems. Durch die Immobilisierung ist es möglich, die Emission eines gegebenen freien, also nichtvernetzten emittierenden Metallkomplexes in Richtung des oder in den blauen Spektralbereich zu verschieben.

In einem dritten Aspekt betrifft die Erfindung die Verwendung eines in einem mehrdimensionalen Netzwerk quervernetzten organischen Metallkomplexes als Emitter oder Absorber in einem optoelektronischen Bauelement, sofern der Metallkomplex ein Licht-Emitter oder -Absorber ist.

Entsprechend betrifft die Erfindung in einem vierten Aspekt auch ein optoelektronisches Bauelement, aufweisend einen quervernetzten organischen Metallkomplex wie hier beschrieben.

Das optoelektronische Bauelement kann eine organischen Leuchtidiode (OLEDs), lichtemittierenden elektrochemischen Zelle (LEECs oder LECs), OLED-Sensoren, optischen Temperatur-Sensoren, organischen Solarzellen (OSCs), organischen Feldeffekttransistoren, organischen Dioden, organischen Photodioden und "down conversion" Systeme betreffen. Derartige Bauelemente sind dem Fachmann bekannt.

In einem fünften Aspekt betrifft die Erfindung ein Verfahren zur Herstellung eines in einem mehrdimensionalen Netzwerk quervernetzten organischen Metallkomplexes, insbesondere einer dünnen Schicht mit einer Dicke von 75 nm bis 300 nm, bevorzugt von 100 nm bis 250 nm, insbesondere zur Herstellung eines optoelektronischen Bauelements.

Das Verfahren weist mindestens die folgenden Schritte auf: Zunächst wird ein Gemisch aus einem ersten Reaktanden in Form eines organischen Metallkomplexes und einem zweiten Reaktanden, also eines Mittels zur Immobilisierung des Metallkomplexes auf einen festen Träger aufgetragen. Der Metallkomplex wird während der durchgeführten ersten Reaktion des ersten mit dem zweiten Reaktanden in dem sich bildenden mehrdimensionalen Netzwerk querverknüpft.

Wie bereits beschrieben erfolgt die Ausbildung der Quervernetzung bevorzugt bei erhöhter Temperatur, bevorzugt zwischen 80 °C bis 120 °C.

Das Auftragen eines Gemisches beiden Reaktanden auf einen festen Träger kann mittels aller im Stand der Technik bekannter Methoden erfolgen, insbesondere mittels Inkjet-Printing, Dipping, Spincoating, Schlitzgießen oder Rakeln (Knife Coating).

In einem sechsten Aspekt betrifft die Erfindung die Verwendung eines quervernetzten Metallkomplexes als Emittermaterial für ein optoelektronisches Bauelement, insbesondere als optoelektronische Tinte.

In einem siebenten Aspekt betrifft die Erfindung einen organischen Metallkomplex mit mindestens einem Metallzentrum und mindestens einem Liganden. Erfindungsgemäß weist der Metallkomplex zwei Ankergruppen einer ersten Ankergruppenspezies zur Reaktion mit einer Ankergruppe einer zweiten Ankergruppenspezies zur Querverknüpfung auf, wobei die Ankergruppe des Metallkomplexes während einer Querverknüpfungsreaktion zu der Ankergruppe eines zweiten Reaktanden, der der Ausbildung eines mehrdimensionalen Netzwerkes dient, eine kovalente Bindung ausbilden kann.

In einem achten Aspekt betrifft die Erfindung die Verwendung eines derartigen Metallkomplexes zur Quervernetzung und Immobilisierung des Metallkomplexes mit einem zweiten Reaktanden, der eine Ankergruppe einer zweiten Ankergruppenspezies aufweist.

In einem neunten Aspekt betrifft die Erfindung ein Verfahren zur Funktionalisierung eines organischen Metallkomplexes mit zwei Ankergruppen, über die der Metallkomplex durch Bindung an ein eine zweite Ankergruppe tragenden zweiten Reaktanden gebunden und so immobilisiert werden kann, da die Ankergruppen einer ersten Ankerguppenspezies des Metallkomplexes mit der Ankergruppe einer zweiten Ankergruppenspezies des zweiten Reaktanden reagiert und eine kovalente Bindung ausbilden kann.

### Figuren

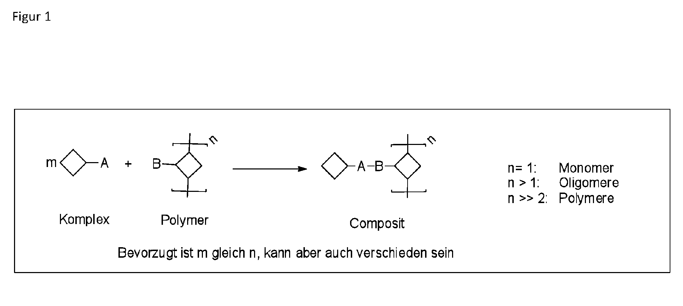

- Figur 1:: Allgemeines Schema für die Verknüpfung von organischen Metallkomplexen (erster Reaktand) mit Monomeren, Oligomeren oder Polymeren (zweiter Reaktand), die jeweils eine entsprechende Ankergruppe tragen, die die Querverknüpfung (Quervernetzung) des Metallkomplexes ermöglicht. Das Reaktionsprodukt ist hier als Composit bezeichnet.
- Figur 2:: Ausgewählte Beispiele für Ankergruppen einer ersten und zweiten Ankergruppenspezies (jeweils in Zeilen angeordnet). Jeweils gegenüberliegend gezeigte Ankergruppen können, gebunden einerseits an den Metallkomplex und andererseits an den zweiten Reaktanden, eine kovalente Bindung zwischen den Reaktanden ausbilden und den Metallkomplex so vernetzen und ihn immobilisieren. Erste und zweite Ankergruppenspezies werden hier als Anker A bzw. Anker B angesprochen. Dabei kann je nach Verwendung der hier dargestellt Anker A die erste oder zweite Ankergruppenspezies, und der Anker B entsprechend die zweite oder erste Ankergruppenspezies darstellen.
- Figur 3:: Beispielreaktion für die Vernetzung eines Alkin-substituierten Kupferkomplexes mit einem polymeren Azid als zweitem Reaktanden. Die gezeigte Kugel steht für Polystyrol, kann aber jedes andere Polymer, Oligomer oder Monomer als zweiten Reaktanden repräsentieren.
- Figur 4:: Histogramm des AFM-Bildes vor und nach dem Spülen mit Xylol (s. Beispiel 3). Die Höhen sind auf 1 normiert, die Lage der Histogramme auf der X-Achse willkürlich, aber maßstabsgetreu. Zur besseren Übersicht wurden die Histogramme nicht über einander, sondern nebeneinander angeordnet. Die Prozessierung erfolgte bei 40 °C, die Scan-Größe der zugrundeliegenden Aufnahmen beträgt 1 µm².

### Beispiele

### Beispiel 1

Für die beschriebene Erfindung sind solche Reaktionen bevorzugt, die neben dem Metallkomplex und dem zweiten Reaktanden ohne den Zusatz eines weiteren Reaktanden, dass heißt höchstens durch einen die weiter Anwendung nicht weiter störenden Katalysator, auskommen. Beispiele für solche Reaktionen sind 1,3-dipolaren Cycloadditionen, Diels-Alder-Reaktionen, Nitron-Alkin-, Nitriloxid-Alkin-, Thiol-En-, Thiol-In-, Thiol-Isocyanat, Tetrazol-Alken- und andere in der chemischen Literatur als Click-Reaktionen bekannte Verfahren.

Bevorzugt sind solche Reaktionen, die von dem im Metallkomplex enthaltenen Metall selbst katalysiert werden, was einer autokatalysierten Quervernetzung entspricht. Als Beispiel hierfür sei die Kupfer-katalysierte Clickreaktion zwischen einem terminalen oder aktivierten Alkin und einem Azid genannt. Diese Reaktion liefert regioselektiv und in hohen Ausbeuten und Umsätzen 1,4-Triazole (s. Figur 2).

### Beispiel 1.1.: Cu-Komplex katalysierte Clickreaktion zwischen terminalen Alkinen und Aziden:

Phenylacetylen (103 mg, 1,0 mmol, 1,0 Äquiv.) und Benzylazid (133 mg, 1,0 mmol, 1,0 Äquiv.) wurden in einem mit einem Septum luftdicht verschließbaren Vial in 10 mL trockenem Dichlormethan gelöst. Der Cu-Komplex (katalytische oder stöchiometrische Mengen) wurde zugegeben, das Vial versiegelt und die Reaktion 2 Tage bei Raumtemperatur gerührt. Zum Entfernen des Katalysator-Komplexes wurde die Reaktionsmischung in 50 mL Methanol gegeben und 20 min gerührt. Der Komplex wurde abfiltriert und das Filtrat eingeengt. Entfernen des Lösungsmittels und Trocknen des Produkts im Hochvakuum ergab die Verbindung 1-Benzyl-4-phenyl-1H-1,2,3-triazol als hellgelben Feststoff in 95 % Ausbeute (245 mg, 0,95 mmol). Die Identität des Produkts wurde eindeutig durch NMR-Spektroskopie, Infrarotspektroskopie und hochauflösende Massenspektrometrie belegt.

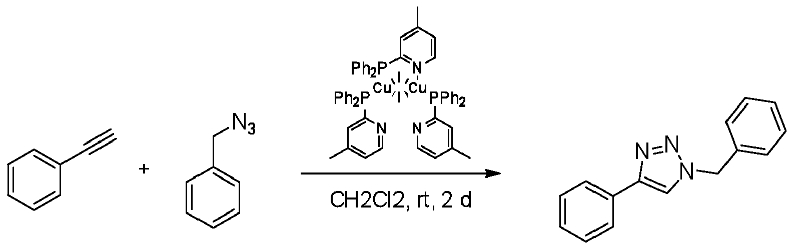

### Beispiel 1.2.: Cu-Komplex katalysierte Clickreaktion zwischen Cu-Alkin-Komplex und Aziden:

Der Cu-Komplex (1,341 g, 1,0 mmol, 1,0 Äquiv.) wurde in einem mit einem Septum luftdicht verschließbaren Vial in 10 mL trockenem Dichlormethan gelöst und Benzylazid (466 mg, 3,5 mmol, 3,5 Äquiv.) zugegeben. Die Reaktion wurde 12 Stunden lang bei Raumtemperatur gerührt, über einen Spritzenfilter filtriert und durch Eintropfen in Diethylether ausgefällt. Waschen des ausgefällten Feststoffs mit Diethylether und Trocknen des Produkts im Hochvakuum ergab die Verbindung Tris-(4-(2-(1-benzyl-1H-1,2,3-triazol-4-yl)ethyl)-2-(diphenylphosphino)pyridin)-di-kupfer-diiodid als hellgrünen Feststoff in 61 % Ausbeute (1,052 g, 0,61 mmol). Die Identität des Produkts wurde eindeutig durch NMR-Spektroskopie, Infrarotspektroskopie, Massenspektrometrie und Elementaranalyse belegt.

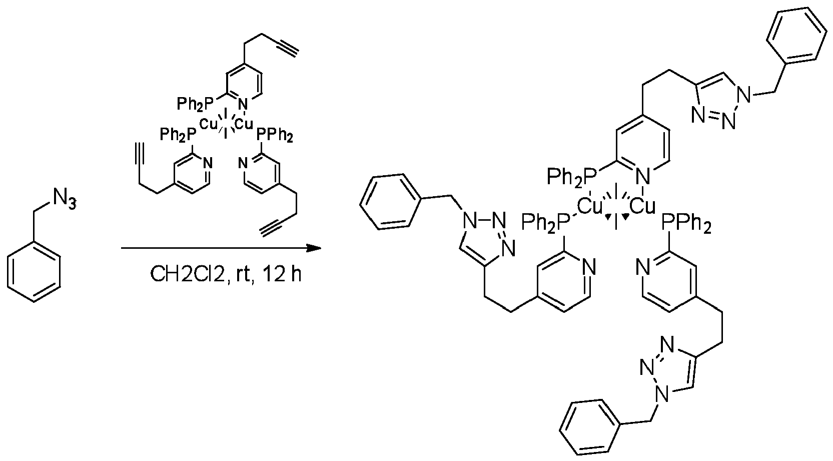

### Beispiel 1.3. Cu-Komplex katalysierte Clickreaktion zwischen Cu-Alkin-Komplex und Polyaziden zur Querverknüpfung:

Der Cu-Komplex (440 mg, 0,33 mmol, 1,0 Äquiv.) wurde als erster Reaktand in einem mit einem Septum luftdicht verschließbaren Vial in 10 mL trockenem Dichlormethan gelöst und mit Poly-(vinylbenzylazid-*alt*-styrol) (370 mg, 1,0 mmol, 3,0 Aquiv.) als zweitem Reaktanden umgesetzt. Die Reaktion wurde 12 Stunden lang bei Raumtemperatur gerührt, wobei das Produkt als unlöslicher grünlicher Feststoff aus der Reaktionslösung ausfiel. Der Niederschlag wurde abgesaugt, mit 20 mL Dichlormethan, 20 mL Diethylether und 20 mL Methanol gewaschen und im Hochvakuum getrocknet. Das Produkt Poly-(4-(2-(1-(4-vinylbenzyl-1H-1,2,3-triazol-4-yl)ethyl)-2-(diphenylphosphino)pyridin)-alt-styrol @ Cul fiel als hellgrüner Feststoff in 66 % Ausbeute an (540 mg, 0,21 mmol) und stellt den quervernetzten Metallkomplex dar. Die Identität des Produkts wurde eindeutig durch Infrarotspektroskopie und Elementaranalyse belegt.

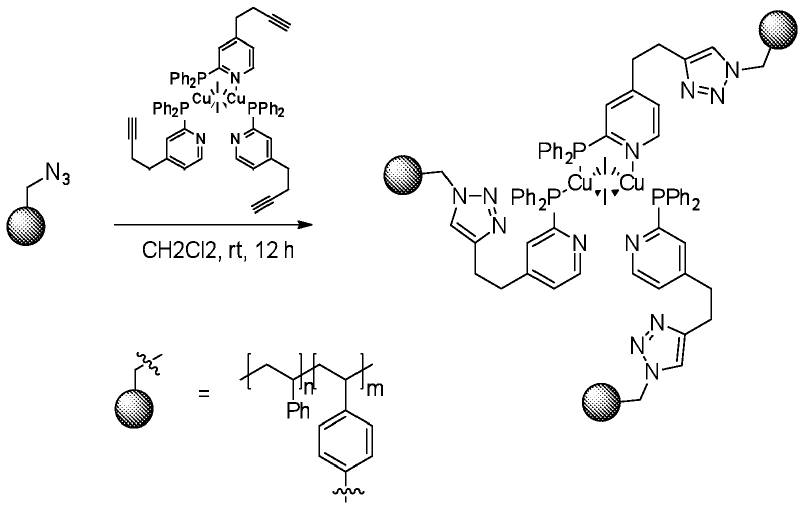

Es wurde gezeigt, dass eine solche Reaktion unlösliche, quervernetzte Metallkomplexe (Composit-Materialien) liefert. Sowohl der Ausgangskomplex 25 als auch das Produkt 26 (s. Figur 2) verfügen dabei über eine gelbe Lumineszenz, deren Spektrum durch die Reaktion nicht weiter beeinflusst oder gestört wird, da die Ankergruppen nicht in Konjugation zum Emittersystem stehen.

Nach dem Auftragen auf einen Objektträger mit einer Rakel-Apparatur (alle weiteren bekannten Druck- oder Beschichtungsverfahren wie bspw. Spincoating, Schlitzgießen oder Ink-Jet sind ebenfalls möglich) zu einer dünnen Schicht und einem Aushärten durch 30-minütiges Erhitzen auf 100 °C wurde diese Schicht stabilisiert und unlöslich. Mit einem derartigen Verfahren lassen sich auf einfachem Wege Mehrschichtanordnungen realisieren, für deren Umsetzung ansonsten orthogonale Lösungsmittel oder photochemische Aushärtungsschritte benötigt werden. Zusätzlich sorgt diese Quervernetzung für eine Stabilisierung und Fixierung der geometrischen Struktur der Metallkomplexe, wodurch eine Bewegung der Liganden und somit eine Strukturänderung der angeregten Moleküle verhindert und eine Effizienzminderung durch strahlungslose Relaxationspfade wirkungsvoll unterbunden wird.

### Beispiel 2

Die Erfindung betrifft in einer bevorzugten Ausführungsform die Herstellung von neuartigen optoelektronischen Tinten als Emittermaterial für organische Leuchtdioden als optoelektronisches Bauelement. Die Tinte beruht dabei in einer Ausführungsform auf elektrolumineszierenden Kupfer(1)-Komplexen, bei denen Diphenylphosphinpyridine, Diphenylphosphinchinoline und verwandte Heterozyklen als Liganden verwendet werden. Diese zweizähnigen Liganden bilden mit Kupfer(I)-iodid mehrkernige Komplexe mit einem Ligand-Metalliodid-Verhältnis von 3:2.

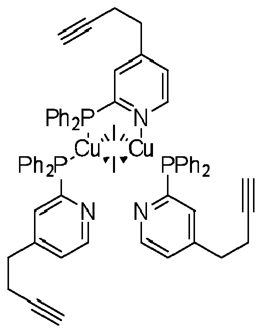

### Struktur von Tris-(4-Butinyl-2-diphenylphosphinopyridin)-bis-(kupferiodid)

Wie in Versuchen gezeigt wurde, lassen sich diese Ligandensysteme mit Alkin-Ketten wie 4-Butin substituieren und als Kupferkomplex (erster Reaktand mit erster Ankergruppe) in einer *Click-*Reaktion mit Aziden kuppeln. Mit dieser Reaktion lassen sich sowohl niedermolekulare als auch polymere Azide als zweiter Reaktand umsetzen, so dass beispielsweise vernetzte, Kupfer-haltige Polymere synthetisiert werden können, die die elektrolumineszierenden Eigenschaften der Metallkomplexe mit den Vorteilen der einfachen flüssigen Verarbeitbarkeit der Polymere verbinden und nach einem Temperschritt robuste, unlösliche Schichten ergeben.

Weiterhin kann diese Reaktion auch mit weiteren Ligandenklassen durchgeführt werden. Gleichzeitig können neben der Quervernetzung weitere Materialfunktionen in die Tinte implementiert werden. Dafür können Click-Reaktionen genutzt werden, um funktionelle Halbleiter (als dritter Reaktand), die lochleitende beziehungsweise elektronenleitende Eigenschaften haben, an die Komplexe zu knüpfen. Wird die Ankergruppe, z. B. der Alkin-Linker, in Konjugation zu den organischen Liganden angeknüpft und aromatische Azide verwendet, so lassen sich die Emissionsfarbe der Komplexe, die auf Charge-Transferübergängen zwischen den Metallionen und den Liganden beruht, beeinflussen. Da die dimeren Komplexe jeweils drei Liganden und damit drei Anknüpfstellen enthalten, lassen sich die Komplexe auf diese Weise sowohl an die Polymere anknüpfen, als auch mit Loch- oder Elektronenleitern verbinden. Die optischen, mechanischen und elektrischen Eigenschaften der so erhaltenen Substanzen lassen sich damit über die jeweilige Zusammensetzung des Azid-Gemisches beeinflussen. Über Roboter-gestützte High-Throughput-Screening-Verfahren lassen sich diese Parameter der Tinte optimieren. Bei der Verwendung verschiedener mit Alkin substituierter Metallkomplexe lassen sich so organische Leuchtdioden in verschiedenen Farben realisieren, durch geeignete Farbmischung der entsprechenden Metallkomplexe können so Weißlicht-OLEDs erzeugt werden.

So lassen sich die Emitter mit einer optimalen Mischung aus Lochleitern, Elektronenleitern und einem Polymer zu einer optoelektronischen Tinte verknüpfen.

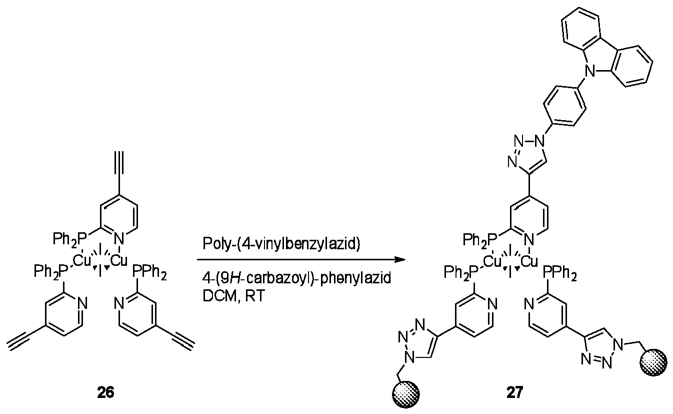

Die in **27** gezeigte Kugel steht für Polystyrol, kann aber jedes andere Polymer, Oligomer oder Monomer als zweiten Reaktanden repräsentieren.

Dabei dient der PyrPHOS-Komplex (Pyridyldiphenylphosphin = PyrPHOS) selbst als Katalysator für die Click-Reaktion. Bei Verwendung von polymeren Aziden mit einem Rückgrat aus Polystyrol oder Polyethylenglykol tritt durch die Komplexierung eine Quervernetzung auf. Durch Prozessierung lässt sich dies nutzen: Wird eine frisch hergestellte Mischung des Alkin-Komplexes und des Azid-Polymers per Spin-Coating oder Rakeln ("knife-coating") auf Glassubstrate aufgetragen und das Substrat für eine Stunde bei 100 °C getempert, so entstehen quervernetzte, unlösliche Schichten.

Auf diese Schichten könnten in weiteren Prozessierungsschritten leicht zusätzliche Ladungstransportschichten aufgetragen werden. Wie durch Photolumineszenz-Spektroskopie gezeigt werden konnte, wird die gelbe Emissionsfarbe der Kupfer-PyrPHOS-Komplexe weder durch Variation der Alkylketten, noch durch die Anknüpfung an die Polymere beeinflusst. Das Emissionsmaximum der PyrPHOS-Systeme liegt bei 550 nm. Dass sich die per Photolumineszenz beobachtete Emissionsfarbe auch im OLED reproduzieren lässt, wurde in einer Einschichtanordnung durch Mischen des Komplexes mit dem Lochleiter CBP gezeigt.

### Beispiel 3

### Auftragen mit der Rakel (Knife Coating):

Mit dem Rakel-Verfahren lassen sich dünne Schichten mithilfe eines keilförmigen Beschichtungsmessers herstellen. Dazu wird die Substanz in Lösung auf das Substrat aufgetragen und durch einen Schlitten, der mit einer definierten Spaltbreite und Zuggeschwindigkeit gesteuert werden kann, gleichmäßig verteilt. Durch Beheizen und einen Stickstoffstrom werden die so erzeugten Filme getrocknet, so dass extrem glatte, definierte Schichten erzeugt werden können.

Zur Herstellung der dünnen Schichten wurde das in Xylol gelöste Polymer mit dem in Dichlormethan gelösten Metallakomplex in einem Vial gemischt und nach einer kurzen Zeit nach dem Zusammengeben als leicht getrübte Lösung auf ein mit Indium-Zinn-Oxid (ITO) und PEDOT:PSS beschichtetes Substrat aufgetragen. Es wurde eine äquimolare Stöchiometrie gewählt.

Die Reaktion, Beschichtung und Trocknung wurden bei verschiedenen Temperaturen durchgeführt. Da der gesamte Prozess nach sehr kurzer Zeit beendet war, wurden die Proben anschließend für eine Stunde auf einer Heizplatte bei 100 °C getempert, um einen möglichst hohen Umsatz der Huisgen-Reaktion zu erreichen. Die Proben wurden unter einer UV-Lampe sowie per Rasterkraftmikroskopie untersucht. Außerdem wurden zur Reaktionskontrolle die Filme vor und nach dem Trocknen durch Eintauchen in Xylol gespült. Während das vernetzte Produkt unlöslich ist, lösen sich die Edukte in diesem Lösemittel, sodass durch die Beständigkeit der Schichten eine Aussage über eine erfolgreiche Quervernetzung möglich ist.

Mit zunehmender Prozesstemperatur stieg auch die Spülbeständigkeit. Nach dem Temperschritt waren alle getesteten Schichten beständig gegen Xylol. Die verschiedenen Proben wurden per AFM (Rasterkraftmikroskop) vermessen, um die Morphologie der Schichten auf nanoskaliger Ebene zu untersuchen.

Durch Rasterkraftmikroskopie konnte der durch optischen Vergleich gewonnene Eindruck, dass sich die Eigenschaften der quervernetzten Proben durch das Spülen nicht mehr verändern lässt, bestätigt werden. Zusätzlich wurde die Rauigkeit R_{q} (Standardabweichung der Höhenverteilungskurve) bestimmt (gemäß E. P. Degarmo, J. T. Black, R. A. Kohser, Materials and Processes in Manufacturing, 2003, 9. Auflage, Wiley, 223). Dazu wurden die gesamte Scanfläche oder bei Verunreinigungen ein Ausschnitt davon ausgewählt. Die Ergebnisse sind in der nachstehenden Tabelle 1 aufgeführt.

Die Rauigkeit ist für die gemessenen Proben mit Werten zwischen 0,53 und 1,64 nm sehr niedrig, was für eine exzellente Morphologie der gemessenen Proben spricht.

**Tabelle 1: Rauigkeit der AFM-Proben. In den ersten vier Proben zeigten sich Pinholes, die Bestimmung erfolgte daher nicht über den gesamten Messbereich, sondern über einen loch-freien Bereich, um repräsentative Ergebnisse zu erhalten.**

| **Probe** | | | **Rauigkeit R_{q}** | **Bezogen auf eine Fläche von** |
|---|---|---|---|---|
| **80** | 11 °C | | 0.66 nm | 0.478 µm² |
| **80** | 11 °C | gespült | 0.99 nm | 0.397 µm² |
| **81** | 25 °C | | 0.53 nm | 0.485 µm² |
| **81** | 25 °C | gespült | 0.70 nm | 0.495 µm² |
| **82** | 40 °C | | 1.64 nm | 1.000 µm² |
| **82** | 40 °C | gespült | 0.91 nm | 1.000 µm² |

In Figur 4 sind zum Vergleich Histogramme gezeigt. Demnach ergeben sich recht scharfe, nahezu Gauß-förmige Höhenverteilungen. Die Standardabweichung dieser Verteilungskurven ist in Tabelle als R_{q} angegeben.

### Beispiel 4

### Gleichzeitige Anknüpfung des Metallkomplexes sowie weiterer Alkine

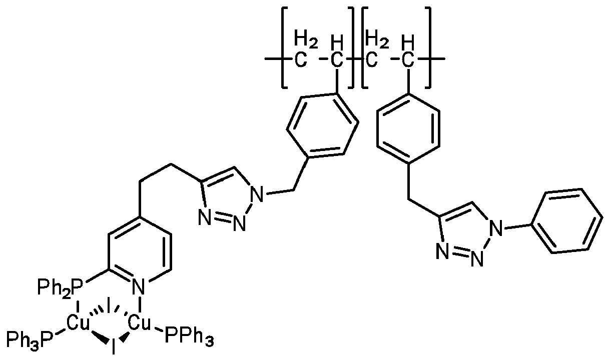

Um auf einfache, modulare Weise sowohl Kupferkomplexe (als erster Reaktand) als Emitter, als auch Ladungstransport-Einheiten (als dritter Reaktand) in ein Polymer (als zweiter Reaktand) zu bringen, wurde der Metallkomplex, ein Überschuss Azid und Phenylacetylen umgesetzt. Es wurden beide Alkine ans Polymer geknüpft. Außerdem luminesziert das Produkt wie erwartet, der Komplex bleibt also intakt.

### Beispiel 5

### Cu(I)-Katalyse mit den PyrPHOS-Komplexen

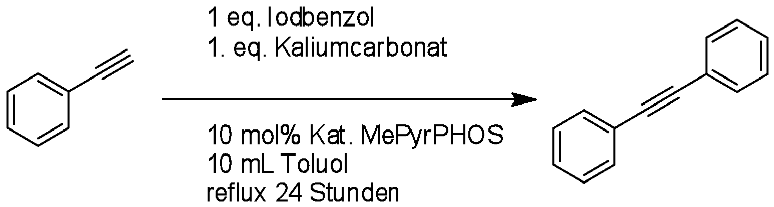

Einerseits sollte das katalytische Potential der PyrPHOS-Systeme über die Cu(I)-Huisgen-Reaktion hinaus evaluiert werden. Mit den unlöslichen, quervernetzen PyrPHOS-Polymeren könnte somit ein Festphasen-Katalysator mit immobilisiertem Cu(I) vorliegen.

Andererseits können mit derartigen Reaktionen die Eigenschaften der Metallkomplexe modifiziert werden, z. B.:

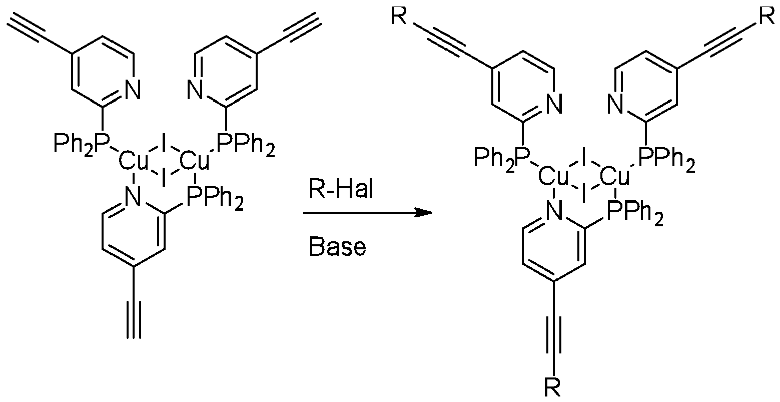

Die oben gezeigte Reaktion lief mit vollständigem Umsatz (mittels IGC-MS bestimmt) ab, außerdem konnte der in Toluol unlöslich Katalysator mit dem Kaliumcarbonat abfiltriert werden und blieb intakt (Erhalt der gelben Photolumineszenz).

### Beispiel 6

### Thiol-En-Reaktion

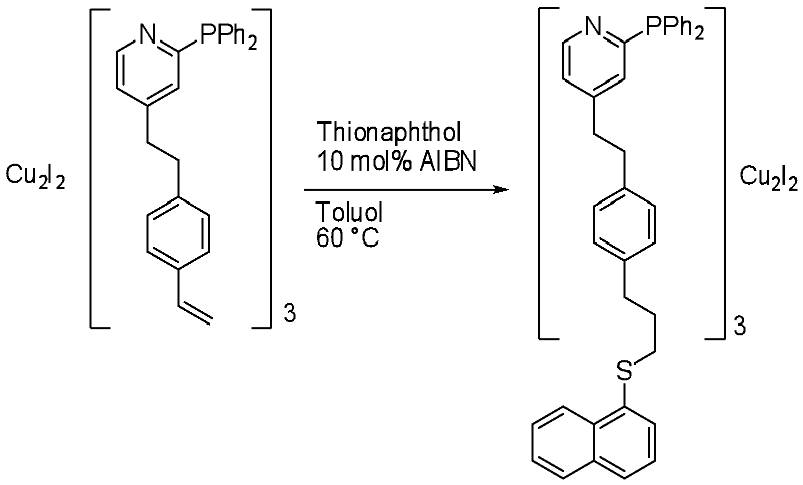

Das rechts gezeigte Produkt luminesziert wie das links gezeigte Edukt. Der typische Geruch eines freien Thiols war nach der Reaktion nicht mehr vorhanden.

## Patentansprüche

1. Verfahren zur Querverknüpfung eines organischen Metallkomplexes in ein mehrdimensionales Netzwerk,
umfassend das Durchführen einer ersten Reaktion, die aufweist
- einen ersten Reaktanden in Form eines organischen Metallkomplexes und
- einen zweiten Reaktanden zur Ausbildung eines mehrdimensionalen Netzwerkes,
wobei der Metallkomplex während der Reaktion in dem sich bildenden mehrdimensionalen Netzwerk querverknüpft wird.

2. Verfahren nach Anspruch 1, wobei
- der Metallkomplex mindestens zwei Ankergruppen einer ersten Ankergruppenspezies zur kovalenten Einbindung des Metallkomplexes in das mehrdimensionale Netzwerk aufweist und
- der zweite Reaktand mindestens eine Ankergruppe einer zweiten Ankergruppenspezies, und wobei die Querverknüpfung des Metallkomplexes durch Reaktion der mindestens zwei Ankergruppen des Metallkomplexes mit je einer zweiten Ankergruppe eines zweiten Reaktanden erfolgt.

3. Verfahren nach Anspruch 1, wobei
- der Metallkomplex mindestens zwei Ankergruppen einer ersten Ankergruppenspezies aufweist und
- der zweite Reaktand eine Ankergruppe einer ersten Ankergruppenspezies aufweist, und wobei
die Querverknüpfung des Metallkomplexes durch Reaktion der Ankergruppe des Metallkomplexes und durch Reaktion der Ankergruppe des zweiten Reaktanden mit einem dritten Reaktanden erfolgt, der zwei Ankergruppen einer zweiten Ankergruppenspezies aufweist, wobei jede dieser Ankergruppen des dritten Reaktanden mit je einer ersten Ankergruppe eine kovalente Bindung eingehen kann.

4. Verfahren nach Anspruch 1 bis 3, wobei das gebildete mehrdimensionale Netzwerk mit querverknüpften organischen Metallkomplexen unlöslich ist.

5. Verfahren nach Anspruch 1 bis 5, wobei der zweite Reaktand ausgewählt ist aus der Gruppe bestehend aus Monomer, Oligomer und Polymer.

6. Verfahren nach Anspruch 1 bis 5, wobei die erste und zweite Ankergruppenspezies ausgewählt ist aus der in Figur 2 gezeigten Gruppe.

7. Verfahren nach Anspruch 1 bis 6, wobei ein vierter Reaktand zum Transport oder zur Blockierung elektrischer Ladungen an der Reaktion teilnimmt, der eine Ankergruppe der ersten oder zweiten Ankergruppenspezies aufweist.

8. Verfahren nach Anspruch 1 bis 7, wobei neben dem ersten Reaktanden, dem zweiten Reaktanden, optional dem dritten Reaktanden und optional dem vierten Reaktanden kein weiterer Reaktand an der Reaktion teilnimmt.

9. Verfahren nach Anspruch 1 bis 8, wobei die Reaktion in Gegenwart eines Katalysators zur Katalyse der Reaktion stattfindet, wobei bevorzugt der Metallkomplex den Katalysator aufweist.

10. Verfahren nach Anspruch 1 bis 9, wobei eine zweite Reaktion zur Herstellung einer Mehrschichtanordnung durchgeführt wird, wobei die zweite Reaktion aufweist
- einen fünften Reaktanden in Form eines organischen Metallkomplexes und
- einen sechsten Reaktanden zur Ausbildung eines mehrdimensionalen Netzwerkes,
wobei
wobei der Metallkomplex während der zweiten Reaktion in dem sich bildenden mehrdimensionalen Netzwerk querverknüpft wird.

11. Querverknüpfter organischer Metallkomplex, herstellbar durch ein Verfahren nach Anspruch 1 bis 10.

12. Verwendung eines quervernetzten organischen Metallkomplexes als Emitter oder Absorber in einem optoelektronischen Bauelement.

13. Optoelektronisches Bauelement, aufweisend einen quervernetzten organischen Metallkomplex nach Anspruch 11, wobei das optoelektronische Bauelement ausgewählt ist aus der Gruppe bestehend aus organischen Leuchtidioden (OLEDs), lichtemittierenden elektrochemischen Zellen (LEECs oder LECs), OLED-Sensoren, insbesondere nicht hermetisch nach außen abgeschirmten Gas-und Dampf-Sensoren, optischen Temperatur-Sensoren, organischen Solarzellen (OSCs), organischen Feldeffekttransistoren, organischen Dioden, organischen Photodioden und "down conversion" Systemen.

14. Verfahren zur Herstellung einer Schicht eines quervernetzten organischen Metallkomplexes, aufweisend die Schritte
- Auftragen eines Reaktionsgemisches aus
- einem ersten Reaktanden in Form eines organischen Metallkomplexes und
- einem zweiten Reaktanden zur Ausbildung eines mehrdimensionalen Netzwerkes
auf einen festen Träger,
wobei der Metallkomplex während der Reaktion des ersten mit dem zweiten Reaktanden in dem sich bildenden mehrdimensionalen Netzwerk querverknüpft wird.

15. Verwendung eines querverknüpften Metallkomplexes nach Anspruch 11 als Emittermaterial (optoelektronischen Tinte) für ein optoelektronisches Bauelement, insbesondere wobei das optoelektronische Bauelement ausgewählt ist aus der Gruppe bestehend aus organischen Leuchtidioden (OLEDs), lichtemittierenden elektrochemischen Zellen (LEECs oder LECs), OLED-Sensoren, insbesondere nicht hermetisch nach außen abgeschirmten Gas- und Dampf-Sensoren, optischen Temperatur-Sensoren, organischen Solarzellen (OSCs), organischen Feldeffekttransistoren, organischen Dioden, organischen Photodioden und "down conversion" Systemen.

16. Organischer Metallkomplex mit mindestens einem Metallzentrum und mindestens einem Liganden,
**gekennzeichnet durch**
zwei Ankergruppen einer ersten Ankergruppenspezies zur Reaktion mit einer Ankergruppe einer zweiten Ankergruppenspezies zur Querverknüpfung,
wobei die Ankergruppe des Metallkomplexes während einer Querverknüpfungsreaktion zu der Ankergruppe eines zweiten Reaktanden zur Ausbildung eines mehrdimensionalen Netzwerkes eine kovalente Bindung ausbildet.

17. Verwendung eines organischen Metallkomplexes nach Anspruch 16 zur Querverknüpfung des Metallkomplexes mit einem zweiten Reaktanden zur Ausbildung eines mehrdimensionalen Netzwerkes.
